# EUROPÄISCHE PATENTSCHRIFT

(11) **EP 1 969 909 B1**
(45) Veröffentlichungstag und Bekanntmachung des Hinweises auf die Patenterteilung: **31.10.2012**
(21) Anmeldenummer: 06841631.2
(22) Anmeldetag: 27.12.2006
(51) Int. Cl.: H05K 5/06, H01R 13/52, H05K 5/02, H01R 13/00

(54) **STEUERGERÄTMODUL, INSBESONDERE IN ODER FÜR EIN KRAFTFAHRZEUG**
CONTROL DEVICE MODULE, ESPECIALLY IN OR FOR A MOTOR VEHICLE
MODULE A APPAREIL DE COMMANDE UTILISE EN PARTICULIER POUR UN VEHICULE A MOTEUR OU DANS CELUI-CI

(30) Priorität: 27.12.2005 DE 102005062602
(43) Veröffentlichungstag der Anmeldung: 17.09.2008
(73) Patentinhaber: ROBERT BOSCH GMBH, 70442 Stuttgart (DE)
(72) Erfinder: MOSER, Manfred, 72768 Reutlingen (DE); WAYAND, Hartmut, 72793 Pfullingen (DE)
(86) Internationale Anmeldenummer: PCT/EP2006/070224
(87) Internationale Veröffentlichungsnummer: WO 2007/074158

(56) Entgegenhaltungen:
- DE-A1- 3 635 165
- DE-A1- 4 140 487
- DE-C2- 3 437 901
- DE-C2- 19 807 215

## Beschreibung

### Stand der Technik

Die vorliegende Erfindung betrifft ein Steuergerätmodul, insbesondere in oder für ein Kraftfahrzeug.

Steuergerätmodule sind Module, die Steuerungsfunktionen übernehmen. Steuergerätmodule sind in einer Vielzahl unterschiedlicher Ausführungsformen und Varianten allgemein bekannt. Ein Beispiel eines solchen Steuergerätmoduls ist in der DE 198 07 215 C2 beschrieben. Obgleich prinzipiell auf beliebige Steuergerätmodule anwendbar, wird die vorliegende Erfindung sowie die ihr zu Grunde liegende Problematik nachfolgend mit Bezug auf Steuergeräte im Kraftfahrzeugbereich und dabei insbesondere mit Bezug auf Motorsteuergeräte erläutert.

Steuergerätmodule weisen typischerweise ein elektrisches Steuergerät, das in einem Gehäuse angeordnet ist, sowie einen Steckverbinder mit Kontaktpins, durch welchen das Steuergerät an einen Kabelbaum des Fahrzeuges ankoppelbar ist, auf. Die elektrischen Bauteile im Innenraum des Gehäuses des Steuergeräts sowie die Kontaktpins des Steckverbinders müssen vor Partikeln und insbesondere Feuchtigkeit aus dem Motorraum geschützt werden, um eine Beschädigung, beispielsweise durch einen Kurzschluss, zu verhindern. Dazu sollen das Gehäuse des Steuergeräts und der Steckverbinder im angekoppelten Zustand dicht gegenüber Feststoffen, Flüssigkeiten und Gasen aus dem Motorraum, typischerweise mittels Dichtungen, ausgebildet sein. Eine solche Dichtigkeit kann jedoch nur bis zu einer vorbestimmten Druckdifferenz aus einem Innendruck im Steuergerätmodul und einem im Motorraum herrschenden Außendruck gewährleistet werden. Übersteigt die Druckdifferenz, beispielsweise auf Grund einer Erwärmung von Luft in dem Innenraum des Steuergeräts, den vorbestimmten Wert, so verformen sich die Dichtungen derart, dass ein Stoffaustausch zwischen dem Steuergerätmodul und dem Motorraum stattfindet. Diesen Stoffaustausch gilt es zu vermeiden.

Ein erster allgemein bekannter Ansatz, der sich mit der oben geschilderten Problematik befasst, sieht eine Entlüftung des Steuergerätes und des Steckverbinders über den angekoppelten Kabelbaum vor.

Dabei besitzt der Kabelbaum gasleitende Litzen, die auf der einen Seite an ein Luftvolumen außerhalb des Motorraums angeschlossen sind und auf der anderen Seite an den Steckverbinder des Steuergerätmoduls angeschlossen sind. Der Steckverbinder selbst wiederum ist mittels eines Kanals mit dem Innenraum des Steuergeräts verbunden. Zieht sich beispielsweise Luft im Innenraum des Steuergeräts auf Grund einer Abkühlung zusammen, so kann von außerhalb des Motorraums durch die Litze im Kabelbaum, durch den Steckverbinder und durch den Kanal Luft in das Innere des Steuergeräts nachgeführt werden, solange bis der Innendruck im Gehäuse wieder im Wesentlichen dem Außendruck im Motorraum entspricht.

Problematisch bei diesem ersten Ansatz ist, dass eine adäquate Entlüftung des Steuergerätmoduls von dem Kabelbaum mit den gasleitenden Litzen abhängt. Wird der Kabelbaum beispielsweise unsachgemäß montiert, so kann es zu einer schlechten Entlüftung und im Folgenden zu einer Beschädigung des Steuergerätmoduls kommen.

Bei einem zweiten allgemein bekannten Ansatz, der sich mit der oben aufgezeigten Problematik befasst, ist eine spezielle Druckausgleichseinrichtung zur Entlüftung des Steuergerätes in dem Steuergerätmodul vorgesehen. Dazu ist der Innenraum des Gehäuses des Steuergeräts durch einen druckleitenden Kanal mit dem Druckausgleichselement verbunden. Das Druckausgleichelement ist dabei typischerweise als gasleitende Membran, die undurchlässig für Feststoffe oder Flüssigkeiten ist, ausgebildet. Folglich erfolgt die Entlüftung bei diesem zweiten Ansatz mittels der Gase im Motorraum, die aber durch die Membran gefiltert werden.

Jedoch besteht bei dem zweiten Ansatz das Problem, dass der Steckverbinder mit angekoppeltem Kabelbaumstecker nicht entlüftet wird. Folglich müssen bei dem zweiten Ansatz Kabelbaumstecker verwendet werden, die eine Abdichtung eines jeden Kontaktpins des Steckverbinders vorsehen, damit sichergestellt ist, dass kein Gasvolumen in dem Raum zwischen dem Steckverbinder und dem Kabelbaumstecker vorhanden ist. Ein vorhandenes, sich ausdehnendes und zusammenziehendes Gasvolumen würde zu einem Eindringen von Stoffen aus dem Motorraum, insbesondere von Feuchtigkeit, führen. Solche Kabelbaumstecker und Steckverbinder sind sehr aufwändig in ihrer Herstellung und bieten oft eine nur teilweise Abdichtung besonders nach häufigem An- und Abkoppeln des Kabelbaumsteckers.

Die DE 36 35 164 A1 offenbart ein Steuergerätemodul nach dem Oberbegriff des Anspruchs 1.

Das erfindungsgemäße Steuergerätmodul mit den Merkmalen des Patentanspruchs 1 weist den Vorteil auf, dass es eine Entlüftung sowohl für ein Steuergerät als auch für eine Steckerbuchse zum Ankoppeln eines Steckers eines elektrischen Kabels bereitstellt. Somit kann eine zuver- lässige Funktion des Steuergerätmoduls über eine lange Zeit gewährleistet werden. Ferner werden diese Vorteile auf eine einfache Weise erreicht.

Das erfindungsgemäße Steuergerätmodul weist das Steuergerät, wenigstens die eine Steckenbuchse , und eine Druckausgleichseinrichtung auf. Das Steuergerät ist in einem geschlossenen Gehäuse angeordnet, in welchem ein erster Innendruck herrscht. Bei angekoppeltem Zustand des Steckers ist ein geschlossener Raum zwischen der Steckenbuchse und dem Stecker definiert, in welchem ein zweiter Innendruck herrscht. Die Druckausgleichseinrichtung dient dem Angleichen des ersten und zweiten Innendrucks an einen Außendruck, der von Außen auf das Steuergerätmodul wirkt.

Die der vorliegenden Erfindung zu Grunde liegende Idee besteht darin, dass ein Angleichen des ersten Innendrucks in dem Steuergerät und des zweiten Innendrucks in dem geschlossenen Raum an einen Außendruck der von außen auf das Steuergerät wirkt, durch lediglich eine Druckausgleichseinrichtung erreicht wird. Dafür werden die Steckenbuchse und das Gehäuse des Steuergeräts beide an die Druckausgleichseinrichtung gekoppelt. Ein Druckausgleich für die Steckenbuchse kann somit ohne eine zusätzliche Druckausgleichseinrichtung erzielt werden. Es ist lediglich eine Ankopplung der an das Druckausgleichselement erforderlich.

Ferner kann bei dieser Lösung auf eine Entlüftung durch den Kabelbaum verzichtet werden. Dies erlaubt einen einfachere Auslegung des Kabelbaums und eine zuverlässigere Entlüftung des Steuergerätmoduls.

In den Unteransprüchen und Figuren der Zeichnung finden sich vorteilhafte Weiterbildungen und Verbesserungen der Erfindung.

In einer Weiterbildung der Erfindung weist das Druckausgleichelement eine Membran auf. Durch diese Membran erfolgt ein Angleichen des ersten und zweiten Innendrucks an den Außendruck. Die Membran ist vorzugsweise flüssigkeits-undurchlässig und/oder gasdurchlässig ausgebildet. Dadurch kann die Expansion und/oder Kompression von Gasen im Inneren des Steuergerätmoduls ungehindert durch die Membran erfolgen. Es wird jedoch sichergestellt, dass keine Flüssigkeiten in das Steuergerät und/oder in die Verbindungseinrichtung eindringen können. Somit wird eine zuverlässige Funktion des Steuergerätmoduls über eine lange Zeit erreicht. In einer besonders vorteilhaften Ausgestaltung der Erfindung weist die Membran ein Gore-Tex- Material auf. Solch eine mikroporöse Membran dient dazu, Flüssigkeitsdämpfe innerhalb des Steuergerätmoduls nach Außen abzuführen und keine Flüssigkeiten in das Steuergerätmodul eindringen zu lassen.

Ferner sieht die Erfindung vor, dass das Gehäuse und die Steckerbuchse jeweils durch ein druckleitendes Element mit der Druckausgleichseinrichtung verbunden sind. Dieses Merkmal erlaubt vorzugsweise eine Leitung des ersten und zweiten Innendrucks an die Druckausgleichseinrichtung und somit ein Angleichen des ersten und zweiten Innendrucks an den Außendruck.

In einer bevorzugten Ausgestaltung ist das druckleitende Element als ein gasleitender Kanal ausgebildet. Vorzugsweise werden die in dem Gehäuse und/oder in der Steckerbuchse enthaltenen Gase bei deren Ausdehnung durch die gasleitenden Kanäle an die Druckausgleichseinrichtung geleitet. Bei einem Zusammenziehen der Gase innerhalb des Gehäuses und/oder innerhalb der Verbindungseinrichtung werden Gase von außerhalb des Steuergerätmoduls durch die Membran und durch die gasleitenden Kanäle in das Gehäuse und/oder in die Steckerbuchse nachgeführt.

Weiterhin weist das druckleitende Element vorzugsweise ein Dichtelement auf, das ein Eindringen von Flüssigkeiten und/oder Partikeln in das Steuergerät und/oder in die Steckerbuchse verhindert. Somit kann beispielsweise bei Reparaturarbeiten, bei denen das elektrische Kabel von dem Steuergerätmodul abgekoppelt wird und später wieder angekoppelt wird, ein Eindringen von Staub oder Feuchtigkeit verhindert werden. Durch ein solches Dichtelement wird vermieden, dass Partikel und/oder Flüssigkeiten von der Steckerbuchse durch das gasleitende Element in das Steuergerät eindringen. In einer besonderen Ausgestaltung der Erfindung ist das Dichtelement als eine Labyrinth-Dichtung ausgebildet. Diese erlaubt eine kostengünstige und verlässliche Abdichtung des druckleitenden Elements gegenüber Flüssigkeiten und/oder Partikeln.

In einer Weiterbildung der Erfindung sind das Gehäuse und die Steckerbuchse gemeinsam auf einem Trägerbauteil angeordnet, welches die Druckausgleichseinrichtung und/oder das Druckleitende Element aufweist. Eine solche räumlich enge Anordnung des Trägers und der Druckausgleichseinrichtung und/oder des druckleitenden Elements kann zu einer verbesserten Raumnutzung führen.

Vorzugsweise ist der Stecker zum Ankoppeln eines Kabelbaums geeignet Nachdem das Steuergerätmodul typischerweise in Kraftfahrzeugen verwendet wird, welche gewöhnlich einen Kabelbaum aufweisen, erleichtert ein derart ausgebildetes Interface einen Einbau und Ausbau des Steuergerätmoduls.

### Zeichnungen

Ausführungsbeispiele der Erfindung sind in den Zeichnungen dargestellt und werden in der nachfolgenden Beschreibung näher erläutert.

Es zeigen:
- Figur 1: eine Aufsicht eines allgemeinen Aufbaus eines erfindungsgemäßen Steuergerätmoduls;
- Figur 2A: eine Aufsicht eines detaillierten Ausführungsbeispiels des erfindungsgemäßen Steuergerätmoduls;
- Figur 2B: einen Schnitt durch das Steuergerätmodul des detaillierten Ausführungsbeispiels aus Figur 2A.

In allen Figuren der Zeichnungen sind gleiche beziehungsweise funktionsgleiche Elemente - sofern nichts Anderes angegeben ist - jeweils mit den gleichen Bezugszeichen versehen worden.

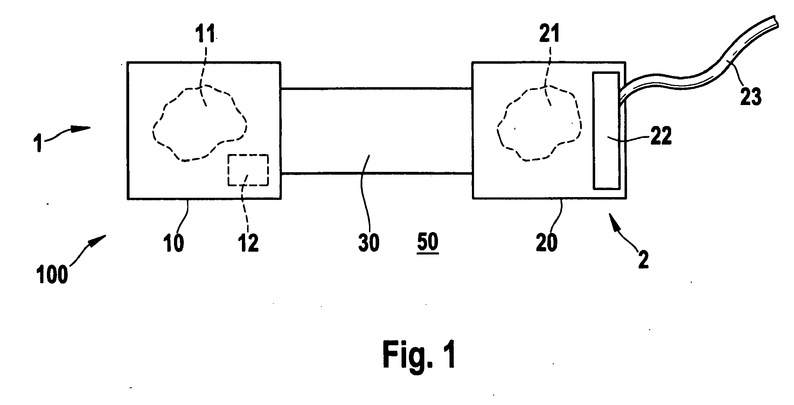

Figur 1 zeigt eine Aufsicht eines allgemeinen Aufbaus des erfindungsgemäßen Steuergerätmoduls. Ein Steuergerät 1 weist elektronische Bauelemente 12 sowie ein geschlossenes Gehäuse 10 auf. Geschlossen bezieht sich hier auf ein stoffdichtes Abschließen des Gehäuses gegenüber Stoffen, beispielsweise Gasen, Flüssigkeiten, oder Partikelstäuben im Motorraum. In dem geschlossenen Gehäuse herrscht ein erster Innendruck 11. Ferner ist eine Steckerbuchse 20 zur Ankopplung eines Steckers 22 eines elektrischen Kabels 23 vorgesehen. Bei angekoppeltem Zustand des Steckers 22 definiert die Steckerbuchse 20 mit dem Stecker 22 einen geschlossenen Raum 20A. Der Terminus geschlossen ist entsprechend der obigen Definition zu lesen. In dem geschlossenen Raum herrscht ein zweiter Innendruck 21. Weiterhin ist eine Druckausgleichseinrichtung 30 zum Angleichen des ersten und zweiten Innendrucks 11, 21 an einen Außendruck 50, der von außen auf das Steuergerätmodul 100 wirkt, vorgesehen. Die Druckausgleichseinrichtung ist dabei an das geschlossene Gehäuse 10 und die Steckerbuchse 20 gekoppelt.

Erhöhen sich beispielsweise der erste und der zweite Innendruck aufgrund einer Temperaturänderung in dem Gehäuse 10 und dem geschlossenen Raum 20A, so werden diese durch die Druckausgleichseinrichtung 30 an den Außendruck 50 angeglichen. Nach dem Druckausgleich entsprechen der erste und zweite Innendruck 11, 21 dem Außendruck.

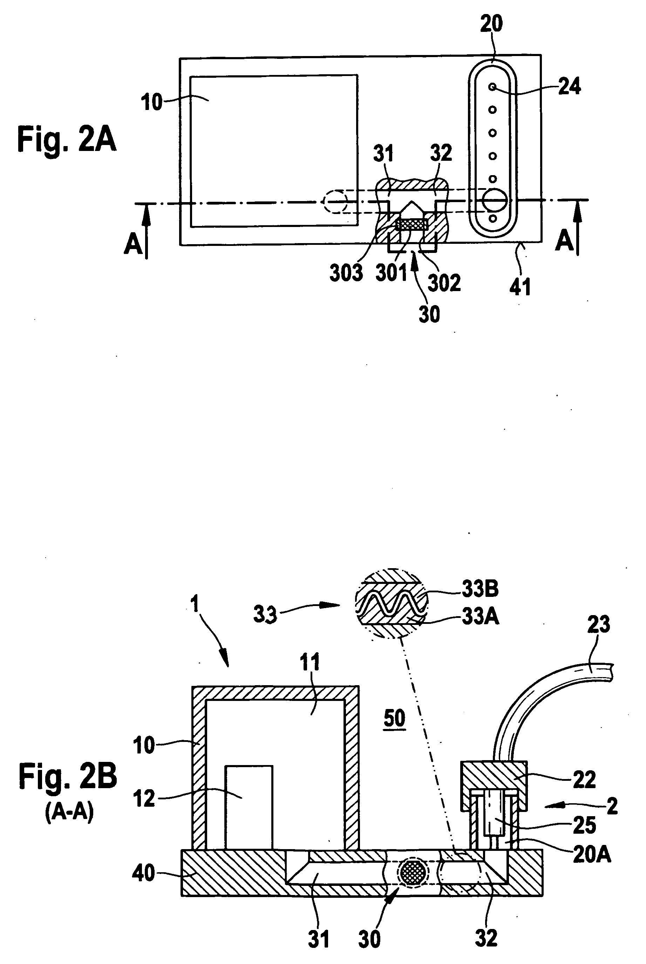

Die Figuren 2A und 2B zeigen eine Aufsicht beziehungsweise einen Schnitt eines detaillierten Ausführungsbeispiels eines erfindungsgemäßen Steuergerätmoduls 100. Das Steuergerät 1 sowie die Verbindungseinrichtung 2 bestchend aus Steckerbuchse 20 und Stecker 22 sind auf einem Träger 40 angeordnet. Die Steckerbuchse 20 besitzt Kontaktpins 24. Der Stecker 22 (nicht in Figur 2A dargestellt) mit Kontakthülsen 25 stellt einen elektrisch leitenden Kontakt zwischen den Kontaktpins und dem Kabel 23 her. Das Kabel 23 ist Bestandteil eines Kabelbaumes. Der Stecker 22 bildet mit der Buchse 20 den geschlossenen Raum 20A. Sowohl der Raum 20A als auch das Gehäuse 10 sind mittels der gasleitenden Kanäle 31, 32 mit der Druckausgleichseinrichtung 30 druckleitend verbunden. Die Druckausgleichseinrichtung 30 sieht eine in dem Träger verschweißte Membran 301 vor. Die Membran 301 verschließt einen gas- und druckleitenden Kanal 302 der eine äußere Fläche 41 des Trägerbauteils 40 mit den innerhalb des Trägerbauteils 40 angeordneten druckleitenden Elementen 31, 32 verbindet. In dem Fall, dass die Membran 301 nicht in dem Trägerbauteil 40 eingeschweißt ist, können alternativ Befestigungsmittel 303 vorgesehen sein, beispielsweise Clipse, welche die Membran 301 in Position halten. Die Druckelemente 31, 32 weisen eine Labyrinth-Dichtung 33A, 33B auf.

Erwärmt sich die in dem Gehäuse 10 enthaltene Luft, so erhöht sich der erste Innendruck 11. Dies bewirkt eine Erhöhung des Drucks in dem druckleitenden Element 31. Somit liegt der Innendruck 11 innenseitig an der Membran 301 an. Übersteigt der Innendruck 11 den Außendruck 50 so strömt Luft durch die Gore-Tex Membran 301. Vermeintliche Feuchtigkeit in der Luft kann in dieser Richtung durch die Gore-Tex Membran 301 transportiert werden. Dies führt zu einer Reduzierung der Luftfeuchtigkeit im Steuergerät 1 sowie zu einem Druckausgleich zwischen dem Innendruck 11 und dem Außendruck 50. Sinkt die Temperatur in dem Gehäuse 10 so senkt sich der Luftdruck 11 ab. Dabei entsteht ein Unterdruck auf der Innenseite der Membran 301. Dies führt zu einem Einströmen von Außenluft durch die Membran in das druckleitende Membran 31 und dann in das Gehäuse 10. Dabei verhindert die Gore-Tex Membran das Eindringen von Feuchtigkeit und Partikeln in der Außenluft durch den Kanal 302. Ein Druckausgleich zwischen dem Außendruck 50 und dem Innendruck 11 wird somit sichergestellt, ohne dass Stoffe, welche die Funktion des Steuergerätes beeinträchtigen können, eindringen.

Während oder vor der Montage oder auch bei Wartungstätigkeiten, ist der Stecker 22 nicht in der Buchse 20 eingesteckt. Das Eindringen von Staubpartikeln oder Feuchtigkeit kann folglich nicht verhindert werden. In diesem Fall verhindert die Labyrinth-Dichtung 33A, 33B ein Eindringen von Staubpartikeln oder von Flüssigkeit in das Steuergerät 1 durch die druckleitenden Elemente 31, 32. Eine hohe Lebensdauer des Steuergerätmoduls 100 sowie dessen zuverlässige Funktion kann somit sichergestellt werden.

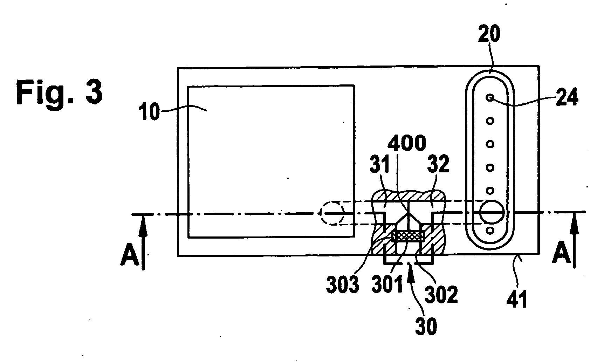

In einem weiteren Ausführungsbeispiel nach Figur 3 ist gezeigt, dass das das Gehäuse 10 und die Steckerbuchse 20 jeweils durch ein druckleitendes Element 31, 32 mit der Druckausgteichseinrichtung 30 verbunden sind, wobei beide druckleitende Elemente 31, 32 nur über die Druckausgleichseinrichtung 30 verbunden sind. Eine Trenn- bzw. Scheidewand 400 trennt beide druckleitende Elemente 31, 32 derart, dass zwischen den beiden druckleitenden Elementen 31, 32 keine direkte Verbindung existiert. Die Membran 301 dichtet in der vorgesehenen Weise sowohl das druckleitende Elements 31 als auch das druckleitende Elements 32 jeweils für sich separat ab.

Die Erfindung ist nicht auf den in den vorstehenden Figuren dargestellten, speziellen Aufbau eines Steuergerätmoduls beschränkt.

In einer Ausgestaltung der Erfindung können beispielsweise mehrerer Steckerbuchsen vorhanden sein, die alle mit der Druckausgleichseinrichtung zum Angleichen der in den Steckerbuchsen und dem Steuergerät herrschenden Innendrücke an einen Außendruck verbunden sind. Dabei können auch mehrere druckleitende Elemente vorgesehen sein. Ferner ist der Einsatz mehrerer Membranen denkbar.

Vorzugsweise ist die Membran derart angeordnet, dass diese mit Flüssigkeit nicht in Berührung kommt.

Alternativ kann der Stecker zum Aufschrauben oder Einhaken vorgesehen sein.

Anstelle der Labyrinth-Dichtung sind eine Vielzahl anderer Dichtungen, wie beispielsweise eine Lippendichtung, denkbar.

## Patentansprüche

1. Steuergerätmodul (100), insbesondere in oder für ein Kraftfahrzeug,
- mit einem Steuergerät (1), welches ein geschlossenes Gehäuse (10) aufweist, in dem ein erster Innendruck (11) herrscht,
- mit wenigstens einer Steckerbuchse (20) zur Ankopplung eines Steckers (22) eines elektrischen Kabels (23), wobei bei angekoppeltem Zustand des Steckers (22) ein geschlossener Raum (20a) zwischen Steckerbuchse und Stecker definiert ist, in welchem ein zweiter Innendruck (21) herrscht, und
- mit einer Druckausgleichseinrichtung (30) zum Angleichen des ersten und zweiten Innendrucks (11, 21) an einen Außendruck (50), der von Außen auf das Steuergerätmodul (100) wirkt, **dadurch gekennzeichnet, dass**
- das Gehäuse (10) und die Steckerbuchse (20) jeweils durch ein druckleitendes Element (31, 32) mit der Druckausgleichseinrichtung (30) verbunden sind.

2. Steuergerätmodul nach Anspruch 1,
**dadurch gekennzeichnet, dass**
die Druckausgleichseinrichtung (30) eine Membran (301) aufweist.

3. Steuergerätmodul nach Anspruch 2,
**dadurch gekennzeichnet, dass**
die Membran (301) Flüssigkeits-undurchlässig und/oder gasdurchlässig ausgebildet ist.

4. Steuergerätmodul nach Anspruch 2 oder 3,
**dadurch gekennzeichnet, dass**
die Membran (301) eine mikroporöse Membran ist, die Flüssigkeitsdämpfe nach Außen abzuführen kann und keine Flüssigkeiten in das Steuergerätmodul eindringen lässt.

5. Steuergerätmodul nach Anspruch 1,
**dadurch gekennzeichnet, dass**
das Gehäuse (10) und die Steckerbuchse (20) jeweils durch ein druckleitendes Element (31, 32) mit der Druckausgleichseinrichtung (30) verbunden sind, wobei beide druckleitende Elemente (31, 32) nur über die Druckausgleichseinrichtung (30) verbunden sind.

6. Steuergerätmodul nach Anspruch 1 oder 5,
**dadurch gekennzeichnet, dass**
das druckleitende Element (31, 32) als ein gasleitender Kanal ausgebildet ist.

7. Steuergerätmodul nach Anspruch 1, 6 oder 7,
**dadurch gekennzeichnet, dass**
das druckleitende Element (31, 32) ein Dichtelement (33) aufweist, das ein Eindringen von Flüssigkeiten und/oder Partikeln in das Steuergerät (1) und/oder in die Steckerbuchse (20) verhindert.

8. Steuergerätmodul nach Anspruch 7,
**dadurch gekennzeichnet, dass**
das Dichtelement (33) als Labyrinth-Dichtung (33A, 33B) ausgebildet ist.

9. Steuergerätmodul nach einem der vorherigen Ansprüche,
**dadurch gekennzeichnet, dass**
das Gehäuse (10) und die Steckerbuchse (20) auf einem Trägerbauteil (40) angeordnet sind, welches die Druckausgleichseinrichtung (30) und/oder das druckleitende Element (31, 32) aufweist.

## Claims

1. Control device module (100), especially in or for a motor vehicle,
- with a control device (1) which has a closed housing (10) in which a first internal pressure (11) prevails,
- with at least one plug socket (20) for the coupling of a plug (22) of an electric cable (23), wherein, in the coupled state of the plug (22), a closed space (20a), in which a second internal pressure (21) prevails, is defined between the plug socket and plug, and
- with a pressure-equalizing device (30) for equalizing the first and second internal pressure (11, 21) with an external pressure (50) which acts on the control device module (100) from the outside, **characterized in that**
- the housing (10) and the plug socket (20) are respectively connected by a pressure-conducting element (31, 32) to the pressure-equalizing device (30).

2. Control device module according to Claim 1, **characterized in that** the pressure-equalizing device (30) has a diaphragm (301).

3. Control device module according to Claim 2, **characterized in that** the diaphragm (301) is designed to be liquid-impermeable and/or gas-permeable.

4. Control device module according to Claim 2 or 3, **characterized in that** the diaphragm (301) is a microporous diaphragm which can conduct liquid vapours to the outside and does not permit any liquids to penetrate the control device module.

5. Control device module according to Claim 1, **characterized in that** the housing (10) and the plug socket (20) are respectively connected by a pressure-conducting element (31, 32) to the pressure-equalizing device (30), wherein the two pressure-conducting elements (31, 32) are connected only via the pressure-equalizing device (30).

6. Control device module according to Claim 1 or 5, **characterized in that** the pressure-conducting element (31, 32) is designed as a gas-conducting channel.

7. Control device module according to Claim 1, 6 or 7, **characterized in that** the pressure-conducting element (31, 32) has a sealing element (33) which prevents liquids and/or particles from penetrating the control device (1) and/or the plug socket (20).

8. Control device module according to Claim 7, **characterized in that** the sealing element (33) is designed as a labyrinth seal (33A, 33B).

9. Control device module according to one of the preceding claims, **characterized in that** the housing (10) and the plug socket (20) are arranged on a support component (40) which has the pressure-equalizing device (30) and/or the pressure-conducting element (31, 32).

## Revendications

1. Module (100) à appareil de commande, en particulier pour un véhicule à moteur ou dans celui-ci,
- comprenant un appareil de commande (1) qui comprend un boîtier fermé (10) dans lequel règne une première pression intérieure (11),
- comprenant au moins une fiche femelle (20) pour le raccordement d'une fiche mâle (22) d'un câble électrique (23), un espace fermé (20a) entre la fiche femelle et la fiche mâle étant défini dans l'état raccordé de la fiche mâle (22), dans lequel espace règne une deuxième pression intérieure (21), et
- comprenant un dispositif d'équilibrage de la pression (30) pour aligner la première et la deuxième pression intérieure (11, 21) sur une pression extérieure (50) qui agit depuis l'extérieur sur le module (100) à appareil de commande, **caractérisé en ce que**
le boîtier (10) et la fiche femelle (20) sont reliés au dispositif d'équilibrage de la pression (30) par un élément communiquant la pression (31, 32) respectif.

2. Module à appareil de commande selon la revendication 1,
**caractérisé en ce que**
le dispositif d'équilibrage de la pression (30) comprend une membrane (301).

3. Module à appareil de commande selon la revendication 2,
**caractérisé en ce que**
la membrane (301) est réalisée de manière imperméable aux liquides et/ou de manière perméable aux gaz.

4. Module à appareil de commande selon la revendication 2 ou 3,
**caractérisé en ce que**
la membrane (301) est une membrane microporeuse qui peut évacuer vers l'extérieur des vapeurs de liquides et ne laisse s'infiltrer aucun liquide dans le module à appareil de commande.

5. Module à appareil de commande selon la revendication 1,
**caractérisé en ce que**
le boîtier (10) et la fiche femelle (20) sont reliés au dispositif d'équilibrage de la pression (30) par un élément communiquant la pression (31, 32) respectif, les deux éléments communiquant la pression (31, 32) n'étant reliés que par l'intermédiaire du dispositif d'équilibrage de la pression (30).

6. Module à appareil de commande selon la revendication 1 ou 5,
**caractérisé en ce que**
l'élément communiquant la pression (31, 32) est réalisé sous forme de canal conduisant les gaz.

7. Module à appareil de commande selon la revendication 1, 6 ou 7,
**caractérisé en ce que**
l'élément communiquant la pression (31, 32) comprend un élément d'étanchéité (33) qui empêche l'infiltration de liquides et/ou de particules dans l'appareil de commande (1) et/ou dans la fiche femelle (20).

8. Module à appareil de commande selon la revendication 7,
**caractérisé en ce que**
l'élément d'étanchéité (33) est réalisé sous forme de joint d'étanchéité à labyrinthe (33A, 33B).

9. Module à appareil de commande selon l'une quelconque des revendications précédentes,
**caractérisé en ce que**
le boîtier (10) et la fiche femelle (20) sont disposés sur une pièce de support (40) qui comprend le dispositif d'équilibrage de la pression (30) et/ou l'élément communiquant la pression (31, 32).
